# FASCICULE DE BREVET EUROPEEN

(11) **EP 3 167 689 B1**
(45) Date de publication et mention de la délivrance du brevet: **22.08.2018**
(21) Numéro de dépôt: 15736456.3
(22) Date de dépôt: 08.07.2015
(51) Int. Cl.: H05B 33/08, H01L 27/15

(54) **CIRCUIT OPTOELECTRONIQUE A DIODES ELECTROLUMINESCENTES A SCINTILLEMENT REDUIT**
OPTOELEKTRONISCHE SCHALTUNG MIT FLIMMERARMEN LEUCHTDIODEN
OPTOELECTRONIC CIRCUIT WITH LOW-FLICKER LIGHT-EMITTING DIODES

(30) Priorité: 11.07.2014 FR 1456708
(43) Date de publication de la demande: 17.05.2017
(73) Titulaire: Aledia, 38040 Grenoble (FR)
(72) Inventeur: MERCIER, Frédéric, F-38500 Saint Nicolas de Macherin (FR); DORNEL, Erwan, F-38600 Fontaine (FR); HUGON, Xavier, F-38470 Teche (FR)
(74) Mandataire: Cabinet Beaumont
(86) Numéro de dépôt international: PCT/EP2015/065605
(87) Numéro de publication internationale: WO 2016/005448

(56) Documents cités:
- EP-A1- 2 523 531
- WO-A1-2012/085118
- US-A1- 2011 199 003

## Description

### Domaine

La présente description concerne un circuit optoélectronique, notamment un circuit optoélectronique comprenant des diodes électroluminescentes.

### Exposé de l'art antérieur

Il est souhaitable de pouvoir alimenter un circuit optoélectronique comprenant des diodes électroluminescentes avec une tension alternative, notamment une tension sinusoïdale, par exemple la tension du secteur.

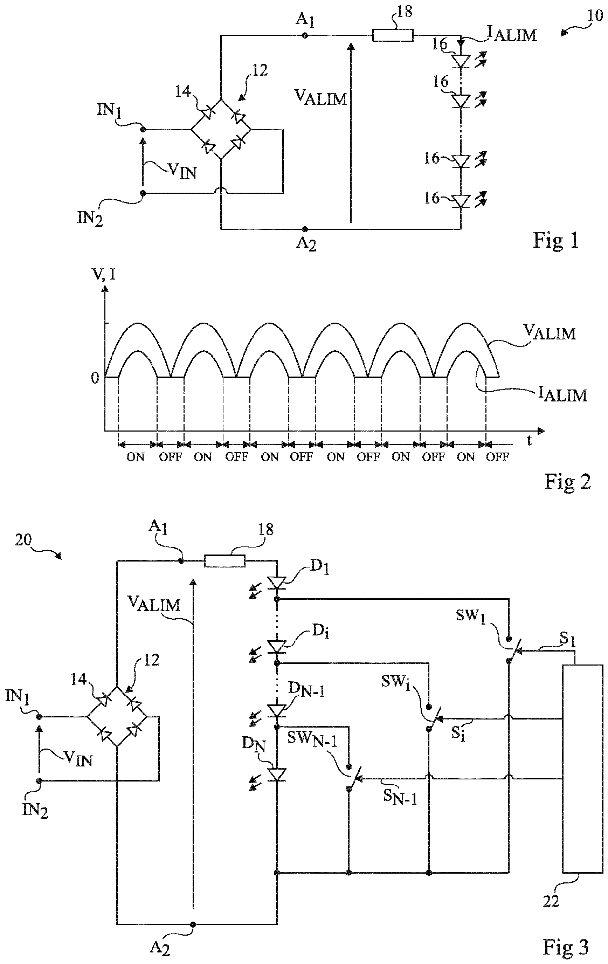

La figure 1 représente un exemple de circuit optoélectronique 10 comprenant des bornes d'entrée IN₁ et IN₂ entre lesquelles est appliquée une tension alternative V_{IN}. Le circuit optoélectronique 10 comprend, en outre, un circuit redresseur 12 comportant un pont de diodes 14, recevant la tension V_{IN} et fournissant une tension V_{ALIM} redressée, entre des noeuds A₁ et A₂, qui alimente des diodes électroluminescentes 16, par exemple montées en série avec une résistance 18. On appelle I_{ALIM} le courant traversant les diodes électroluminescentes 16.

La figure 2 est un chronogramme de la tension d'alimentation V_{ALIM} et du courant d'alimentation I_{ALIM} pour un exemple dans lequel la tension alternative V_{IN} correspond à une tension sinusoïdale. Lorsque la tension V_{ALIM} est supérieure à la somme des tensions de seuil des diodes électroluminescentes 16, les diodes électroluminescentes 16 deviennent passantes. Le courant d'alimentation I_{ALIM} suit alors la tension d'alimentation V_{ALIM}. Il y a donc une alternance de phases OFF d'absence d'émission de lumière et de phases ON d'émission de lumière.

Un inconvénient est que tant que la tension V_{ALIM} est inférieure à la somme des tensions de seuil des diodes électroluminescentes 16, aucune lumière n'est émise par le circuit optoélectronique 10. Un observateur peut percevoir cette absence d'émission de lumière lorsque la durée de chaque phase OFF d'absence d'émission de lumière entre deux phases ON d'émission de lumière est trop importante. Une possibilité pour augmenter la durée de chaque phase ON est de diminuer le nombre de diodes électroluminescentes 16. Un inconvénient est alors que la puissance électrique perdue dans la résistance 18 est importante.

La figure 3 représente un autre exemple de circuit optoélectronique 20. Les éléments communs avec le circuit optoélectronique 10 sont désignés par les mêmes références. Les diodes électroluminescentes élémentaires sont regroupées en N ensembles de diodes électroluminescentes élémentaires, appelés diodes électroluminescentes globales Dᵢ dans la suite de la description, N étant un nombre entier supérieur ou égal à 2. Le circuit optoélectronique 20 comprend N-1 interrupteurs SW₁ à SW_{N-1}. Chaque interrupteur SWᵢ relie la cathode de la diode électroluminescente Dᵢ et le noeud A₂. Chaque interrupteur SWᵢ est commandé par un signal de commande Sᵢ fourni par un module de commande 22.

Lors d'une phase de croissance de la tension d'alimentation V_{ALIM}, les interrupteurs SW₁ à SW_{N-1} sont ouverts successivement de façon que le nombre de diodes électroluminescentes recevant la tension d'alimentation V_{ALIM} augmente progressivement. Lors d'une phase de décroissance de la tension d'alimentation V_{ALIM}, les interrupteurs SW_{N-1} à SW₁ sont fermés successivement de façon que le nombre de diodes électroluminescentes recevant la tension d'alimentation V_{ALIM} diminue progressivement. Ceci permet de réduire la durée de chaque phase d'absence d'émission de lumière.

Un inconvénient du circuit optoélectronique 20 est que le module de commande 22 doit être adapté à fournir les signaux d'ouverture ou de fermeture des interrupteurs SWᵢ aux bons moments en fonction de l'évolution de la tension d'alimentation V_{ALIM}. La structure du module de commande 22 peut être relativement complexe.

En outre, il peut être souhaitable de réaliser chaque interrupteur SWᵢ par un transistor, par exemple un transistor à effet de champ à grille métal-oxyde ou transistor MOS, notamment pour réaliser au moins en partie le circuit optoélectronique 20 par des procédés classiques de fabrication de circuits intégrés. Le signal Sᵢ correspond alors à la tension appliquée à la grille du transistor. Un inconvénient du circuit optoélectronique 20 est que les tensions appliquées aux bornes, notamment entre le drain et la source, d'au moins certains des transistors SWᵢ sont proches de la tension V_{ALIM} et peuvent dépasser 100 V. Il est alors nécessaire d'utiliser des composants électroniques spécifiques compatibles avec des tensions élevées. En outre, le module de commande 22 doit produire des commandes différentes pour tous les transistors SWᵢ, ce qui peut augmenter la complexité du module de commande 22.

Le document US 2011/199003 décrit un circuit optoélectronique comprenant des diodes électroluminescentes en série et des transistors couplés aux bornes des diodes électroluminescentes.

### Résumé

Un objet d'un mode de réalisation est de palier tout ou partie des inconvénients des circuits optoélectroniques décrits précédemment.

Un autre objet d'un mode de réalisation est de réduire la durée des phases d'absence d'émission de lumière du circuit optoélectronique.

Un autre objet d'un mode de réalisation est de réduire l'encombrement du circuit optoélectronique.

Un autre objet d'un mode de réalisation est que le circuit optoélectronique peut être réalisé en totalité de façon intégrée.

Un mode de réalisation selon l'invention est défini dans la revendication 1; ce mode de réalisation prévoit un circuit optoélectronique destiné à recevoir une tension variable contenant une alternance de phases croissantes et décroissantes, le circuit optoélectronique comprenant :
une alternance d'éléments résistifs et d'ensembles de diodes électroluminescentes montés en série, chaque ensemble comprenant deux bornes, chaque élément résistif étant interposé entre deux ensembles successifs ;
pour chaque ensemble parmi une pluralité desdits ensembles, un transistor à effet de champ à grille métal-oxyde à appauvrissement dont le drain et la source sont couplés aux bornes dudit ensemble et dont la grille est couplée à l'une des bornes de l'ensemble suivant ;
pour au moins certains des transistors un élément résistif supplémentaire couplé entre le drain ou la source du transistor et l'une de borne de l'ensemble.
Selon un mode de réalisation, le circuit optoélectronique comprend N ensembles où N est un nombre entier compris entre 2 et 200, et comprenant pour chacun des N-1 ensembles, un transistor à effet de champ à grille métal-oxyde à appauvrissement dont le drain et la source sont couplés aux bornes dudit ensemble et dont la grille est couplée à l'une des bornes de l'ensemble suivant.

Selon un mode de réalisation, au moins certains des éléments résistifs ont des valeurs de résistance différentes.

Selon un mode de réalisation, chaque élément résistif comprend au moins une résistance électrique.

Selon un mode de réalisation, le circuit optoélectronique comprend, en outre, un circuit redresseur double alternance adapté à fournir ladite tension.

Selon un mode de réalisation, le circuit optoélectronique comprend, en outre, un circuit intégré comportant les ensembles de diodes électroluminescentes, les éléments résistifs et les transistors.

Selon un mode de réalisation, chaque diode électroluminescente est une diode plane.

Selon un mode de réalisation, le circuit optoélectronique comprend, en outre, un circuit intégré comprenant un support, les ensembles de diodes électroluminescentes reposant sur le support, chaque diode électroluminescente comprenant au moins un élément semiconducteur filaire, conique ou tronconique.

Selon un mode de réalisation, le circuit optoélectronique comprend, en outre, au moins une couche isolante recouvrant au moins partiellement le support, et, pour chaque transistor, une portion semiconductrice s'étendant sur la couche isolante et formant la source, le drain du transistor et le canal du transistor, une portion isolante recouvrant la portion semiconductrice du côté opposé à la couche isolante et formant l'isolant de grille du transistor.

Selon un mode de réalisation, le support comprend un substrat semiconducteur non dopé ou dopé d'un premier type de conductivité, le circuit optoélectronique comprenant, pour chaque transistor, des régions semiconductrices dopées d'un deuxième type de conductivité et plus fortement dopées que le substrat, s'étendant dans le substrat et formant la source, le drain et le canal du transistor et une portion isolante s'étendant sur le substrat et formant l'isolant de grille du transistor.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, est un schéma électrique d'un exemple d'un circuit optoélectronique comprenant des diodes électroluminescentes ;
la figure 2, décrite précédemment, est un chronogramme de la tension et du courant d'alimentation des diodes électroluminescentes du circuit optoélectronique de la figure 1 ;
la figure 3, décrite précédemment, est un schéma électrique d'un autre exemple d'un circuit optoélectronique comprenant des diodes électroluminescentes ;
la figure 4 représente un schéma électrique d'un mode de réalisation d'un circuit optoélectronique comprenant des diodes électroluminescentes qui n'est pas partie de la présente invention; les figures 5 et 6 illustrent deux agencements des diodes électroluminescentes du circuit optoélectronique de la figure 4 ;
la figure 7 représente un schéma électrique d'un mode de réalisation d'un circuit optoélectronique comprenant des diodes électroluminescentes selon l'invention ;
les figures 8A et 8B sont des vues en coupe, partielles et schématiques, d'un mode de réalisation du circuit optoélectronique représenté en figure 4 ou 7 formé de façon intégrée ; et
les figures 9A à 9C sont des vues en coupe, partielles et schématiques, d'un autre mode de réalisation du circuit optoélectronique représenté en figure 4 ou 7 formé de façon intégrée.

### Description détaillée

Par souci de clarté, de mêmes éléments ont été désignés par de mêmes références aux différentes figures et, de plus, les diverses figures ne sont pas tracées à l'échelle. Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %. Par ailleurs, dans la présente description, on utilise le terme "connecté" pour désigner une liaison électrique directe, sans composant électronique intermédiaire, par exemple au moyen d'une piste conductrice, et le terme "couplé" ou le terme "relié", pour désigner soit une liaison électrique directe (signifiant alors "connecté"), soit une liaison via un ou plusieurs composants intermédiaires (résistance, condensateur, etc.).

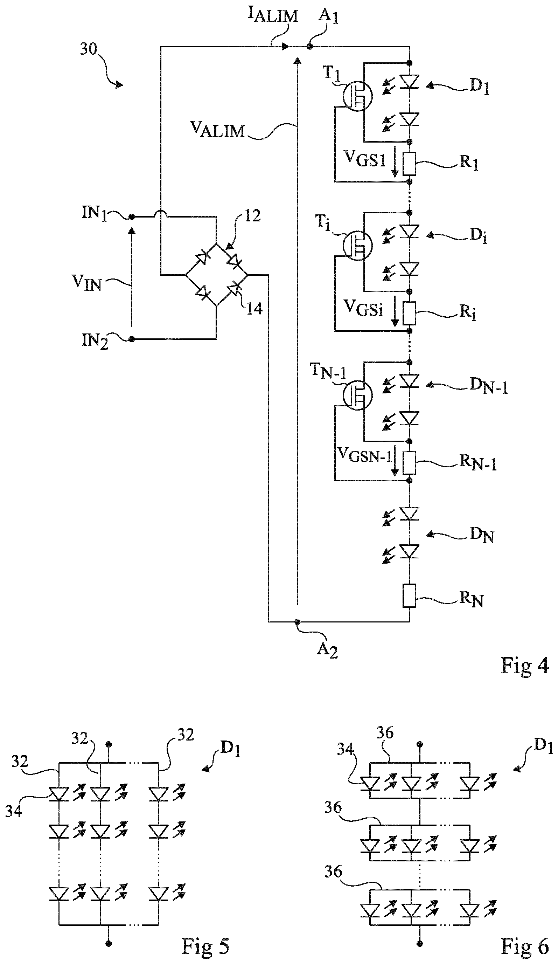

La figure 4 représente un schéma électrique d'un circuit optoélectronique 30. Les éléments communs avec le circuit optoélectronique 20 représenté en figure 3 sont désignés par les mêmes références. A titre d'exemple, la tension d'entrée V_{IN} peut être une tension sinusoïdale, notamment une tension sinusoïdale dont la fréquence est comprise entre 10 Hz et 1 MHz. La tension V_{IN} correspond, par exemple, à la tension du secteur. Le nombre N de diodes électroluminescentes globales est, par exemple, compris entre 2 et 200.

Pour i variant de 1 à N, le circuit optoélectronique 30 comprend une résistance Rᵢ en série avec la diode électroluminescente Dᵢ. Les résistances Rᵢ ont des valeurs différentes. Chaque diode électroluminescente globale D₁ à D_{N} comprend au moins une diode électroluminescente élémentaire et est, de préférence, composée de la mise en série et/ou en parallèle d'au moins deux diodes électroluminescentes élémentaires. Dans le présent mode de réalisation, pour i variant de 1 à N-1, la cathode de la diode électroluminescente globale Dᵢ est couplée à une borne de la résistance Rᵢ et l'autre borne de la résistance Rᵢ est couplée à l'anode de la diode électroluminescente Dᵢ₊₁. L'anode de la diode électroluminescente globale D₁ est couplée au noeud A₁. La cathode de la diode électroluminescente D_{N} est couplée à une borne de la résistance R_{N} et l'autre borne de la résistance R_{N} est couplée au noeud A₂. Les diodes électroluminescentes globales Dᵢ, i variant de 1 à N, peuvent comprendre le même nombre de diodes électroluminescentes élémentaires ou des nombres différents de diodes électroluminescentes élémentaires.

Pour i variant de 1 à N-1, le circuit optoélectronique 30 comprend un transistor MOS Tᵢ comprenant des première et deuxième bornes de puissance, à savoir le drain et la source, et une borne de commande, à savoir la grille. La première borne de puissance du transistor Tᵢ est couplée à l'anode de la diode électroluminescente globale Dᵢ et la deuxième borne de puissance du transistor Tᵢ est couplée à la cathode de la diode électroluminescente globale Dᵢ. La grille du transistor Tᵢ est couplée à l'anode de la diode électroluminescente Dᵢ₊₁. Le corps, ou région de formation de canal, du transistor Tᵢ est relié à la deuxième borne de puissance du transistor Tᵢ. Dans la suite de la description, on considère que la première borne de puissance du transistor Tᵢ correspond au drain et la deuxième borne de puissance du transistor Tᵢ correspond à la source. On appelle V_{GSi} la tension entre la grille et la source du transistor Tᵢ. La tension V_{GSi} correspond à la tension aux bornes de la résistance Rᵢ.

Chaque transistor Tᵢ est un transistor MOS à appauvrissement, également appelé transistor MOS à déplétion. Il s'agit d'un transistor MOS qui est dit normalement passant (en anglais normally on), ce qui signifie qu'il est à l'état passant lorsque la tension V_{GSi} est égale à 0 V. Le transistor Tᵢ est à l'état bloqué lorsque la tension V_{GSi} est négative et inférieure à une tension de seuil de tension négative, par exemple de l'ordre de -1 V. Selon un mode de réalisation, les transistors Tᵢ sont identiques pour i variant de 1 à N-1. En particulier, les tensions de seuil des transistors Tᵢ sont identiques. Selon un autre mode de réalisation, les transistors sont différents. En particulier, les tensions de seuil des transistors Tᵢ sont différentes.

Lorsque le transistor Tᵢ est à l'état passant, il court-circuite la diode électroluminescente globale Dᵢ associée qui n'est alors pas traversée par le courant I_{ALIM}. Lorsque le transistor Tᵢ est à l'état bloqué, la diode électroluminescente globale Dᵢ associée est traversée par le courant I_{ALIM}.

La figure 5 représente un mode de réalisation de la diode électroluminescente globale D₁ dans lequel la diode électroluminescente globale D₁ comprend R branches 32 montées en parallèle, chaque branche comprenant S diodes électroluminescentes élémentaires 34 montées en série dans le même sens passant, R et S étant des nombres entiers supérieurs ou égaux à 1.

La figure 6 représente un autre mode de réalisation de la diode électroluminescente globale D₁ dans lequel la diode électroluminescente globale D₁ comprend P blocs 36 montés en série, chaque bloc comprenant Q diodes électroluminescentes élémentaires 34 montées en parallèle, P et Q étant des nombres entiers supérieurs ou égaux à 1 et Q pouvant varier d'un bloc à l'autre.

Les diodes électroluminescentes globales D₂ à D_{N} peuvent avoir une structure analogue à la diode électroluminescente globale D₁ représentée en figure 5 ou 6.

Les diodes électroluminescentes élémentaires 32 peuvent correspondre à des composants discrets. A titre de variante, l'ensemble des diodes électroluminescentes élémentaires 32 ou certaines d'entre elles peuvent être réalisées de façon intégrée sur un seul circuit. Les autres composants électroniques du circuit optoélectronique, notamment les résistances et les transistors, peuvent être des composants discrets ou peuvent être réalisés, au moins en partie, de façon intégrée.

Les diodes électroluminescentes élémentaires 32 peuvent être réalisées sur un premier circuit qui est distinct d'un deuxième circuit sur lequel sont réalisés les autres composants électroniques du circuit optoélectronique. Le premier circuit est, par exemple, fixé au deuxième circuit par une liaison du type "puce retournée" (en anglais flip-chip).

A titre de variante, les diodes électroluminescentes élémentaires 32 peuvent être réalisées de façon intégrée avec les autres composants électroniques du circuit optoélectronique ou une partie d'entre eux.

Les diodes électroluminescentes élémentaires 32 sont, par exemple, des diodes électroluminescentes planes ou des diodes électroluminescentes formées à partir d'éléments tridimensionnels, notamment des microfils ou nanofils semiconducteurs, comprenant, par exemple, un matériau semiconducteur à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI.

Le fonctionnement du circuit optoélectronique 30 va maintenant être décrit pour un exemple dans lequel la tension V_{ALIM} fournie par le pont redresseur 12 est une tension sinusoïdale rectifiée comprenant une succession de cycles dans chacun desquels la tension V_{ALIM} augmente depuis la valeur nulle, passe par un maximum et diminue jusqu'à la valeur nulle.

A l'instant initial, au début d'un cycle, la tension V_{ALIM} est nulle. Le courant I_{ALIM} est donc également nul et les tensions V_{GSi} sont égales à 0 V pour i variant de 1 à N-1. Tous les transistors Tᵢ sont alors à l'état passant. Lorsque la tension aux bornes de la diode électroluminescente globale D_{N} passe au-dessus de la tension de seuil de la diode électroluminescente globale D_{N}, la diode électroluminescente globale D_{N} devient passante. Au fur et à mesure que la tension V_{ALIM} augmente, le courant I_{ALIM} qui est fixé par les résistances Rᵢ, i variant de 1 à N, augmente. De ce fait, chaque tension V_{GSi}, qui est négative, augmente en valeur absolue. Toutefois, comme les résistances Rᵢ ont des valeurs différentes, les tensions V_{GSi} sont différentes. Pour i variant de 1 à N-1, à chaque fois que la tension V_{GSi} devient inférieure, en valeur négative, à la tension de seuil du transistor Tᵢ, celui-ci passe à l'état bloqué. Pour i variant de 1 à N-1, les transistors Tᵢ passent à l'état bloqué à des instants successifs qui dépendent des valeurs des résistances Rᵢ et de l'évolution de la tension d'alimentation V_{ALIM}. La résistance Rᵢ est, en outre, choisie pour que, lorsque le transistor Tᵢ passe à l'état bloqué, la tension appliquée aux bornes de la diode électroluminescente globale Dᵢ soit supérieure à la tension de seuil équivalente de la diode électroluminescente globale Dᵢ. Cette tension de seuil équivalente est égale à la somme des tensions de seuil des diodes électroluminescentes en série constituant la diode électroluminescente globale Dᵢ. Ainsi la diode électroluminescente globale Dᵢ est passante après commutation à l'état bloqué du transistor. Dans une phase décroissante de la tension V_{ALIM}, les transistors Tᵢ passent successivement de l'état bloqué à l'état passant en court-circuitant les diodes électroluminescentes globales Dᵢ associées.

Selon une variante, chaque résistance Rᵢ, ou certaines d'entre elles, peut être remplacée par un composant électronique ou un ensemble de composants électroniques ayant une résistance équivalente à Rᵢ. Selon un exemple, chaque résistance Rᵢ peut être formée par plusieurs résistances, éventuellement de même valeur, montées en parallèle.

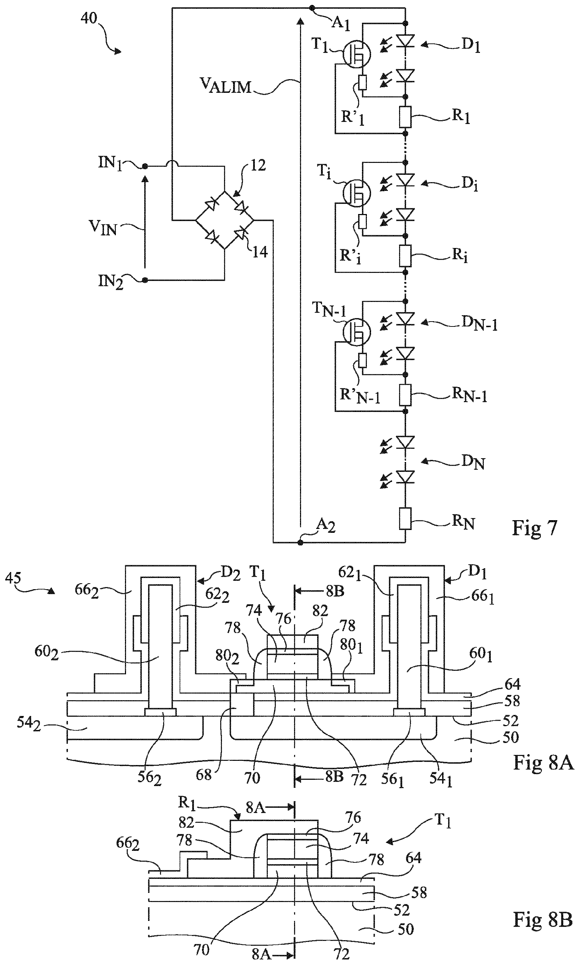

La figure 7 représente un schéma électrique d'un mode de réalisation d'un circuit optoélectronique 40 selon l'invention. Le circuit optoélectronique 40 comprend l'ensemble des éléments du circuit optoélectronique 30 et comprend, en outre, pour chaque transistor Tᵢ, i variant de 1 à N-1, une résistance R'ᵢ montée entre la source du transistor Tᵢ et la cathode de la diode électroluminescente globale Dᵢ. A titre de variante, la résistance R'ᵢ peut être montée entre le drain du transistor Tᵢ et l'anode de la diode électroluminescente globale Dᵢ.

A un instant donné, au cours de l'évolution de la tension V_{ALIM}, la résistance équivalente des résistances en conduction du circuit optoélectronique 40 est sensiblement égale à la somme de toutes les résistances R₁ à R_{N} et de chaque résistance R'ᵢ en série avec un transistor Tᵢ qui est à l'état passant. La tension V_{RES EQUIVALENTE} aux bornes de cette résistance équivalente est égale à V_{ALIM} diminuée de la somme des tensions aux bornes des diodes électroluminescentes globales Dᵢ en conduction. Le courant traversant le circuit optoélectronique 40 est donc égal au rapport entre la tension V_{RES EQUIVALENTE} et la résistance équivalente des résistances en conduction. Ceci signifie que la résistance équivalente du circuit optoélectronique 40 est maximale lorsque la tension V_{ALIM} est nulle, diminue par paliers lors d'une phase de croissance de la tension V_{ALIM}, à chaque fois que l'un des transistors Tᵢ passe à l'état bloqué, est minimale lorsque la tension V_{ALIM} est maximale et augmente par paliers lors d'une phase de décroissance de la tension V_{ALIM}, à chaque fois que l'un des transistors Tᵢ devient passant. Le courant résultant est donc minimal lorsque V_{ALIM} est nulle, augmente par paliers, à chaque fois que l'un des transistors Tᵢ passe à l'état bloqué, est maximal lorsque la tension V_{ALIM} est maximale et diminue par paliers lors d'une phase de décroissance de la tension V_{ALIM}, à chaque fois que l'un des transistors Tᵢ devient passant. Ceci permet avantageusement d'augmenter le facteur de puissance du circuit optoélectronique 40 par rapport au circuit optoélectronique 30.

Un avantage des modes de réalisation décrits précédemment est que le circuit optoélectronique 30, 40 ne comprend pas de module de contrôle adapté à commander la mise à l'état passant ou bloqué des transistors Tᵢ. En effet, le passage entre les états passant et bloqué de chaque transistor Tᵢ est réalisé de façon automatique au cours de l'évolution de la tension V_{ALIM}. La structure du circuit optoélectronique 30, 40 est donc particulièrement simple. Un autre avantage est que, comme la commande de diodes électroluminescentes est réalisée par des transistors MOS et des résistances, ces composants électroniques peuvent de façon avantageuse être réalisés de façon intégrée avec les diodes électroluminescentes.

Les circuits optoélectroniques 30 et 40 décrits précédemment peuvent être réalisés par un dispositif optoélectronique comprenant des diodes électroluminescentes planes ou formées à partir d'éléments tridimensionnels, par exemple des microfils, des nanofils, des éléments coniques ou des éléments tronconiques. Dans la suite de la description, des modes de réalisation vont être décrits pour des diodes électroluminescentes formées à partir de microfils ou de nanofils. Toutefois, ces modes de réalisation peuvent être mis en oeuvre pour des éléments tridimensionnels autres que des microfils ou des nanofils, par exemple des éléments tridimensionnels en forme de pyramide.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

Les figures 8A et 8B sont des coupes d'un mode de réalisation d'un dispositif optoélectronique 45 comprenant des diodes électroluminescentes et des transistors MOS réalisés de façon intégrée. Le dispositif optoélectronique 45 peut être utilisé pour réaliser les circuits optoélectroniques 30 et 40 décrits précédemment.

Sur les figures 8A et 8B, on a seulement représenté les diodes électroluminescentes globales D₁, D₂. En outre, on a représenté à titre d'exemple une seule diode électroluminescente élémentaire pour chaque diode électroluminescente globale D₁, D₂.

En figure 8A, on a représenté une structure de dispositif optoélectronique 45 comprenant :
- un substrat semiconducteur 50, non dopé ou faiblement dopé d'un premier type de conductivité, comprenant une face supérieure 52, de préférence plane au moins au niveau des diodes électroluminescentes ;
- des régions semiconductrices 54₁, 54₂ s'étendant dans le substrat 50 depuis la face 52, dopées d'un deuxième type de conductivité opposé au premier type, et plus fortement dopées que le substrat 50 ;
- des plots de germination 56₁, 56₂ favorisant la croissance de fils et disposés sur la face 52, chaque plot de germination 56₁, 56₂ étant au contact de la région dopée 54₁, 54₂ sous-jacente ;
- une couche isolante 58 recouvrant la face 52 et une partie de chaque plot de germination 56₁, 56₂ ;
- des fils 60₁, 60₂ (deux fils étant représentés à titre d'exemple), chaque fil 60₁, 60₂ étant en contact avec l'un des plots de germination 56₁, 56₂ au travers de la couche isolante 58 ;
- une coque 62₁, 62₂ comprenant un empilement de couches semiconductrices recouvrant une portion supérieure de chaque fil 60₁, 60₂ ;
- une couche isolante 64 s'étendant sur la couche isolante 58 et sur les flancs latéraux de chaque fil 60₁, 60₂ non recouverts par la coque 62₁, 62₂ et sur la partie inférieure de la coque 62₁, 62₂ ;
- une couche 66₁, 66₂ formant une électrode recouvrant chaque coque 62₁, 62₂ et s'étendant, en outre, sur une partie de la couche isolante 64 ;
- une portion semiconductrice 68 dopée du deuxième type de conductivité s'étendant au travers des couches isolantes 58 et 64 au contact de la région semiconductrice dopée 54₁ ;
- une région semiconductrice 70 dopée du deuxième type de conductivité s'étendant sur la couche isolante 64 et au contact de la portion semiconductrice 68 ;
- une portion isolante 72 s'étendant sur une partie de la région semiconductrice 70 ;
- une portion semiconductrice 74 s'étendant sur la portion isolante 72, éventuellement recouverte d'une portion de siliciure 76 ;
- des espaceurs isolants 78 de part et d'autre de la portion semiconductrice 74, les parties de la région semiconductrice 70 non recouvertes par les espaceurs 78 et la portion isolante 72 pouvant être recouvertes d'une portion siliciurée 80₁, 80₂, l'électrode 66₁ venant au contact de la portion siliciurée 80₁ le long d'un bord de celle-ci et l'électrode 66₂ venant au contact de la portion siliciurée 80₂ ;
- une portion semiconductrice ou métallique 82 au contact de la portion siliciurée 76 et s'étendant sur la couche isolante 64 et venant au contact de l'électrode 66₂ comme cela est représenté sur la figure 8B.

La figure 8B est une vue en coupe dont le plan de coupe est perpendiculaire au plan de coupe de la figure 8A. La portion 82 recouvre l'un des espaceurs 78, s'étend sur une partie de la couche isolante 64 et vient au contact de l'électrode 66₂ dans le plan de la figure 8B. Le matériau et la géométrie de la portion 82 sont ajustés pour obtenir la valeur de la résistance R₁. A titre d'exemple, la longueur de la portion 82 reposant sur la couche isolante 64 peut être augmentée pour obtenir une valeur de résistance R1 plus grande. A titre d'exemple, l'épaisseur de la portion 82 peut être augmentée pour obtenir une valeur de résistance R1 plus faible. A titre de variante, la portion 82 peut venir recouvrir l'un des espaceurs 78 et peut venir au contact de l'électrode 66₂ dans le plan de la figure 8A. A titre de variante, l'électrode 66₂ peut être confondue avec la portion semiconductrice 82.

Il peut être prévu une couche conductrice, non représentée, recouvrant la couche d'électrode 66₁, 66₂, entre les fils 60₁, 60₂ mais ne s'étendant pas sur les fils 60₁, 60₂. Une couche d'encapsulation, non représentée, recouvrant l'ensemble de la structure et notamment chaque couche d'électrode 66₁, 66₂ peut être prévue. Le dispositif optoélectronique 45 peut, en outre, comprendre une couche de luminophores, non représentée, confondue avec la couche d'encapsulation, ou prévue sur la couche d'encapsulation.

Le fil 60₁ et la coque 62₁ associée forment une diode électroluminescente élémentaire de la diode électroluminescente globale D₁ et le fil 60₂ et la coque 62₂ associée forment une diode électroluminescente élémentaire de la diode électroluminescente globale D₂. Dans le présent mode de réalisation, le support sur lequel reposent les diodes électroluminescentes comprend le substrat 50 et les plots de germination 56₁, 56₂. La portion semiconductrice 74 forme la grille du transistor T₁. La portion isolante 72 forme l'isolant de grille du transistor T₁. Le canal du transistor T₁ correspond à la zone de la région semiconductrice 70 recouverte par la portion isolante 72. Le drain et la source du transistor T₁ correspondent aux zones latérales de la région semiconductrice 70. La résistance R₁ est formée par la portion semiconductrice 82. A titre de variante, la résistance R₁ peut être formée par une région semiconductrice formée dans le substrat 50.

Dans le présent mode de réalisation, le substrat semiconducteur 50 correspond à une structure monolithique. Le substrat 50 semiconducteur est, par exemple, un substrat en silicium, en germanium, en carbure de silicium, en un composé III-V, tel que du GaN ou du GaAs, ou un substrat en ZnO. De préférence, le substrat 50 est un substrat de silicium monocristallin. Le substrat 50 est un substrat non dopé ou faiblement dopé avec une concentration de dopants inférieure ou égale à 5*10¹⁶ atomes/cm3, de préférence sensiblement égale à 10¹⁵ atomes/cm3. Le substrat 50 a une épaisseur comprise entre 275 µm et 1,5 mm, de préférence 725 µm. Dans le cas d'un substrat 50 de silicium, des exemples de dopants de type P sont le bore (B) ou l'indium (In) et des exemples de dopants de type N sont le phosphore (P), l'arsenic (As), ou l'antimoine (Sb). De préférence, le substrat 50 est dopé de type P au Bore.

Les plots de germination 56₁, 56₂ appelés également îlots de germination, sont en un matériau favorisant la croissance des fils 60₁, 60₂. A titre de variante, les plots de germination 56₁, 56₂ peuvent être remplacés par une couche de germination recouvrant la face 52 du substrat 50 dans la zone associée à chaque diode électroluminescente D₁, D₂. En outre, les plots de germination 56₁, 56₂ assurent la continuité électrique entre les fils 60₁, 60₂ et les régions dopées 54₁, 54₂ sous-jacentes. A titre d'exemple, le matériau composant les plots de germination 56₁, 56₂ peut être un nitrure, un carbure ou un borure d'un métal de transition de la colonne IV, V ou VI du tableau périodique des éléments ou une combinaison de ces composés. Les plots de germination 56₁, 56₂ peuvent être dopés du même type de conductivité que le substrat 50.

Les plots de germination 56₁, 56₂ peuvent être obtenus par le dépôt d'une couche de germination sur la face 52 et par la gravure de portions de la couche de germination jusqu'à la face 52 du substrat 50 pour délimiter les plots de germination. La couche de germination peut être déposée par un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy), l'épitaxie en phase vapeur aux hydrures (HVPE, acronyme anglais pour Hydride Vapor Phase Epitaxy) peuvent être utilisés ou un procédé de dépôt de couche mince atomique (ALD, acronyme anglais pour Atomic Layer Déposition). En outre, des procédés tels l'évaporation ou la pulvérisation cathodique réactive peuvent être utilisés.

Lorsque les plots de germination 56₁, 56₂ sont en nitrure d'aluminium, ils peuvent être sensiblement texturés et posséder une polarité préférentielle. La texturation des plots 56₁, 56₂ peut être obtenue par un traitement supplémentaire réalisé après le dépôt de la couche de germination. Il s'agit, par exemple, d'un recuit sous flux d'ammoniac (NH₃).

Les couches isolantes 58, 64 peuvent être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (SiOₓN_{y} où x peut être environ égal à 1/2 et y peut être environ égal à 1, par exemple du Si₂ON₂), en oxyde d'aluminium (Al₂O₃), en oxyde d'hafnium (HfO₂) ou en diamant. A titre d'exemple, l'épaisseur de chaque couche isolante 58, 64 est comprise entre 5 nm et 800 nm, par exemple égale à environ 30 nm.

Les fils 60₁, 60₂ sont, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils 60₁, 60₂ peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 60₁, 60₂ peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Les fils 60₁, 60₂ peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La section droite des fils 60₁, 60₂ peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. Le diamètre moyen de chaque fil 60₁, 60₂ peut être compris entre 50 nm et 2,5 µm. La hauteur de chaque fil 60₁, 60₂ peut être comprise entre 250 nm et 50 µm. Chaque fil 60₁, 60₂ peut avoir une structure semiconductrice allongée selon un axe sensiblement perpendiculaire à la face 52. Chaque fil 60₁, 60₂ peut avoir une forme générale cylindrique. Les axes de deux fils adjacents d'une même diode électroluminescente globale peuvent être distants de 0,5 µm à 10 µm et de préférence de 1,5 µm à 5 µm. A titre d'exemple, les fils 60₁, 60₂ peuvent être régulièrement répartis, notamment selon un réseau hexagonal.

A titre d'exemple, la portion inférieure de chaque fil 60₁, 60₂ est principalement constituée du composé III-N, par exemple du nitrure de gallium, dopé du même type que le substrat 50, par exemple de type N, par exemple au silicium. La portion inférieure 60₁, 60₂ s'étend sur une hauteur qui peut être comprise entre 100 nm et 25 µm.

A titre d'exemple, la portion supérieure de chaque fil 60₁, 60₂ est au moins partiellement réalisée dans un composé III-N, par exemple du GaN. La portion supérieure peut être dopée du même type que la portion inférieure du fil 60₁, 60₂, par exemple de type N, éventuellement moins fortement dopée que la portion inférieure ou ne pas être intentionnellement dopée. La portion supérieure s'étend sur une hauteur qui peut être comprise entre 100 nm et 25 µm.

Le procédé de croissance des fils 60₁, 60₂ peut être un procédé du type CVD, MOCVD, MBE, GSMBE, PAMBE, ALE, HVPE, ALD. En outre, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.

A titre d'exemple, le procédé de croissance des fils peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBP), l'arsine (AsH₃), ou le diméthylhydrazine asymétrique (UDMH).

Selon un mode de réalisation dans une première phase de croissance des fils du composé III-V, un précurseur d'un élément supplémentaire est ajouté en excès en plus des précurseurs du composé III-V. L'élément supplémentaire peut être le silicium (Si). Un exemple de précurseur du silicium est le silane (SiH₄).

La présence de silane parmi les gaz précurseurs entraîne l'incorporation de silicium au sein du composé GaN. On obtient ainsi une portion inférieure de fils 60₁, 60₂ dopée de type N. En outre, ceci se traduit par la formation d'une couche de nitrure de silicium, non représentée, qui recouvre le pourtour de la portion de fils 60₁, 60₂, à l'exception du sommet au fur et à mesure de la croissance de la portion inférieure.

Pour la croissance de la portion supérieure, les conditions de fonctionnement utilisées pour la croissance de la portion inférieure sont, à titre d'exemple, maintenues à l'exception du fait que le flux du précurseur de l'élément supplémentaire, par exemple le silane, est réduit ou arrêté. Même lorsque le flux de silane est arrêté, la portion supérieure de fils 60₁, 60₂ peut être dopée de type N en raison de la diffusion dans cette portion active de dopants provenant des portions passivées adjacentes ou en raison du dopage résiduel du GaN.

La coque 62₁, 62₂ peut comprendre un empilement de plusieurs couches comprenant notamment :
- une couche active recouvrant la portion supérieure du fil 60₁, 60₂ associé ;
- une couche intermédiaire de type de conductivité opposé à la portion inférieure du fil 60₁, 60₂ et recouvrant la couche active ; et
- une couche de liaison recouvrant la couche intermédiaire et recouverte par l'électrode 66₁, 66₂.

La couche active est la couche depuis laquelle est émise la majorité du rayonnement fourni par la diode électroluminescente élémentaire. Selon un exemple, la couche active peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion supérieure du fil 60₁, 60₂ de type N de la jonction P-N ou P-I-N.

La couche de liaison peut correspondre à une couche semiconductrice ou à un empilement de couches semiconductrices et permet la formation d'un contact ohmique entre la couche intermédiaire et l'électrode 66₁, 66₂. A titre d'exemple, la couche de liaison peut être dopée très fortement du type opposé à la portion inférieure de chaque fil 60₁, 60₂, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 66₁, 66₂ est adaptée à polariser la couche active de chaque fil 60₁, 60₂ et à laisser passer le rayonnement électromagnétique émis par les diodes électroluminescentes. Le matériau formant l'électrode 66₁, 66₂ peut être un matériau transparent et conducteur tel que de l'oxyde d'indium-étain (ou ITO, acronyme anglais pour Indium Tin Oxide), de l'oxyde de zinc dopé à l'aluminium ou du graphène. A titre d'exemple, la couche d'électrode 66₁, 66₂ a une épaisseur comprise entre 5 nm et 200 nm, de préférence entre 20 nm et 50 nm.

La couche d'encapsulation peut être réalisée en un matériau isolant au moins partiellement transparent. L'épaisseur minimale de la couche d'encapsulation est comprise entre 250 nm et 50 µm de sorte que la couche d'encapsulation recouvre complètement chaque électrode 66₁, 66₂ au sommet des ensembles de diodes électroluminescentes D₁, D₂. La couche d'encapsulation peut être réalisée en un matériau inorganique au moins partiellement transparent. A titre d'exemple, le matériau inorganique est choisi parmi le groupe comprenant les oxydes de silicium du type SiOₓ où x est un nombre réel compris entre 1 et 2 ou SiO_{y}N_{z} où y et z sont des nombres réels compris entre 0 et 2 et les oxydes d'aluminium, par exemple Al₂O₃. La couche d'encapsulation peut être réalisée en un matériau organique au moins partiellement transparent. A titre d'exemple, la couche d'encapsulation est un polymère silicone, un polymère époxyde, un polymère acrylique ou un polycarbonate.

La portion semiconductrice 68 peut être composée des mêmes matériaux que le substrat 50. Elle peut être formée par épitaxie ou par dépôt après ouverture des couches isolantes 58 et 64.

La région semiconductrice 70 peut être composée des mêmes matériaux que le substrat 50. La région semiconductrice 70 peut avoir une épaisseur comprise entre 10 nm et 500 nm. La région semiconductrice 70 peut être formée par dépôt puis mise en forme par gravure après une étape de photolithographie.

La portion isolante 72 peut être en oxyde de silicium du type SiOₓ où x est un nombre réel compris entre 1 et 2 ou SiO_{y}N_{z} où y et z sont des nombres réels compris entre 0 et 2, en oxyde d'hafnium HfO₂, en oxyde de lanthane La₂0₃, en oxyde de zirconium Zr0₂, en oxyde de tantale Ta₂0₃ ou bien un composé de ces précédents matériaux. La portion isolante 72 peut avoir une épaisseur comprise entre 1 nm et 25 nm. La portion isolante 72 peut être formée par dépôt ou par oxydation de la région semiconductrice 70.

La portion semiconductrice 74 peut être en silicium polycristallin, en nitrure de titanium (TiN), en tungstène (W), en nitrure de tantale (TaN), en tantale (Ta) ou en platine (Pt) ou bien un multi-couche de ces matériaux. La portion semiconductrice 74 peut avoir une épaisseur comprise entre 10 nm et 200 nm. La portion semiconductrice 74 peut être formée par CVD, par dépôt physique en phase vapeur (PVD, acronyme anglais pour Physical Vapor Déposition) ou par dépôt chimique en phase plasma (PECVD, acronyme anglais pour Plasma-Enhanced CVD).

La portion semiconductrice ou métallique 82 peut être en silicium polycristallin, tungstène, cuivre, nickel, molybdène, argent, or, palladium, platine ou un alliage par exemple en Fer-Nickel (FeNi) ou en Fer-Nickel-Cobalt (FeNiCo). La portion semiconductrice ou métallique 82 peut avoir une épaisseur comprise entre 10 nm et 150 nm. La portion semiconductrice 82 peut être formée par dépôt puis mise en motif par des étapes de photolithographie et gravure.

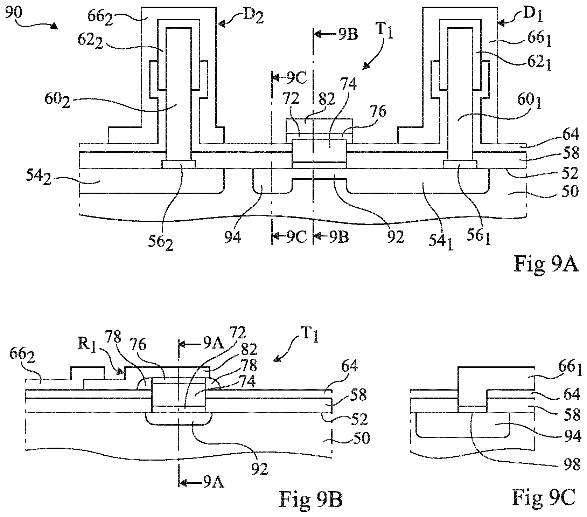

Les figures 9A, 9B et 9C sont des coupes d'un autre mode de réalisation d'un dispositif optoélectronique 90. Les éléments communs avec le dispositif optoélectronique 45 représenté sur les figures 8A et 8B sont désignés par les mêmes références. Le dispositif optoélectronique 90 comprend des régions semiconductrices supplémentaires 92, 94 dopées du même type de conductivité que la région 54₁ et qui s'étendent dans le substrat 50 depuis la face 52. La région semiconductrice 92 forme le canal du transistor T₁ et le drain et la source du transistor T₁ sont formés dans les régions semiconductrices 54₁ et 94. La portion isolante 72, formant l'isolant de grille du transistor T₁, repose sur la région semiconductrice dopée 92. L'électrode 66₁ est en contact électrique avec la région semiconductrice 94 au travers des couches isolantes 58, 64, éventuellement par l'intermédiaire d'une portion siliciurée 98.

La figure 9B est une vue en coupe dont le plan de coupe est perpendiculaire au plan de coupe de la figure 9A. La portion 82 recouvre l'un des espaceurs 78 et peut venir au contact de l'électrode 66₂ dans le plan de la figure 9B. A titre de variante, la portion 82 peut venir au contact de l'électrode 66₂ dans le plan de la figure 9A. A titre de variante, l'électrode 66₂ peut être confondue avec la portion semiconductrice 82.

## Revendications

1. Circuit optoélectronique (30 ; 40) destiné à recevoir une tension variable (V_{ALIM}) contenant une alternance de phases croissantes et décroissantes, le circuit optoélectronique comprenant :
- une alternance de N éléments résistifs (Rᵢ) et de N ensembles (Dᵢ) de diodes électroluminescentes, les éléments résistifs (Rᵢ) étant montés en série avec les ensembles (Dᵢ), chaque ensemble (Dᵢ) comprenant deux bornes, le i^{ème} élément résistif (Rᵢ), pour i variant de 1 à N-1, étant interposé entre deux ensembles (Dᵢ) successifs ;
- un transistor (Tᵢ) pour chaque ensemble (Dᵢ) dans une pluralité desdits ensembles (Dᵢ), **caractérisé en ce que**
le transistor (Tᵢ) est un transistor à effet de champ à grille métal-oxyde à appauvrissement dont le drain et la source sont couplés aux bornes dudit ensemble et dont la grille est couplée à l'une des bornes de l'ensemble suivant, et
**en ce que**
pour au moins certains des transistors (Tᵢ), un élément résistif supplémentaire (R'ᵢ) est couplé entre le drain ou la source du transistor et l'une des bornes dudit ensemble (Dᵢ).

2. Circuit optoélectronique selon la revendication 1, dans lequel N est un nombre entier compris entre 2 et 200 et dans lequel la pluralité d'ensembles (Di) de diodes électroluminescentes avec ledit transistor (Tᵢ) comprend N-1 ensembles.

3. Circuit optoélectronique selon la revendication 1 ou 2, dans lequel au moins certains des éléments résistifs (Rᵢ) ont des valeurs de résistance différentes.

4. Circuit optoélectronique selon l'une quelconque des revendications 1 à 3, dans lequel chaque élément résistif (Rᵢ) comprend au moins une résistance électrique.

5. Circuit optoélectronique selon l'une quelconque des revendications 1 à 4, comprenant, en outre, un circuit (12) redresseur double alternance adapté à fournir ladite tension (V_{ALIM}) .

6. Circuit optoélectronique selon l'une quelconque des revendications 1 à 5, comprenant un circuit intégré (45 ; 90) comportant les ensembles (Dᵢ) de diodes électroluminescentes, les éléments résistifs (Rᵢ) et les transistors (Tᵢ).

7. Circuit optoélectronique selon l'une des revendications 1 à 6, dans lequel chaque diode électroluminescente est une diode plane.

8. Circuit optoélectronique selon l'une des revendications 1 à 6, comprenant un circuit intégré comprenant un support (50, 56₁, 56₂), les ensembles de diodes électroluminescentes (Dᵢ) reposant sur le support, chaque diode électroluminescente comprenant au moins un élément semiconducteur filaire (60₁, 60₂), conique ou tronconique.

9. Circuit optoélectronique selon la revendication 8, comprenant, en outre, au moins une couche isolante (58, 64) recouvrant au moins partiellement le support (50, 56₁, 56₂), et, pour chaque transistor (Tᵢ), une portion semiconductrice (70) s'étendant sur la couche isolante et formant la source, le drain du transistor et le canal du transistor, une portion isolante (72) recouvrant la portion semiconductrice du côté opposé à la couche isolante et formant l'isolant de grille du transistor.

10. Circuit optoélectronique selon la revendication 8, dans lequel le support (50, 56₁, 56₂) comprend un substrat semiconducteur (50) non dopé ou dopé d'un premier type de conductivité, le circuit optoélectronique comprenant, pour chaque transistor (Tᵢ), des régions semiconductrices (94, 92, 54₁) dopées d'un deuxième type de conductivité et plus fortement dopées que le substrat, s'étendant dans le substrat et formant la source, le drain et le canal du transistor et une portion isolante (72) s'étendant sur le substrat et formant l'isolant de grille du transistor.

## Patentansprüche

1. Eine optoelektronische Schaltung (30; 40) zum Empfangen einer variablen Spannung (V_{ALIM}), die eine Alternation bzw. Wechseln von zunehmenden und abnehmenden Phasen enthält, wobei die optoelektronische Schaltung Folgendes aufweist:
ein Wechsel von N Widerstandelementen (Rᵢ) und von N Sätzen (Dᵢ) von Lichtemittierenden Dioden, wobei die Widerstandselemente (Rᵢ) mit den Sätzen (Dᵢ) in Reihe angeordnet sind, wobei jeder Satz (Dᵢ) zwei Anschlüsse aufweist, wobei jedes i^{te} Widerstandselement (Rᵢ), für i in dem Bereich von 1 bis N-1, zwischen zwei aufeinanderfolgenden Sätzen (Dᵢ) angeordnet ist;
einen Transistor (Tᵢ) für jeden Satz (Dᵢ) aus einer Vielzahl von Sätzen (Dᵢ), **dadurch gekennzeichnet, dass**
der Transistor (Tᵢ) ein Verarmungs-Metalloxid-Gate-Feldeffekttransistor ist, dessen Abfluss bzw. Drain und dessen Quelle bzw. Source mit den Anschlüssen der Sätze gekoppelt sind, und der sein Gate zu einem der Anschlüsse des nächsten Satzes gekoppelt hat, und
dass
für wenigstens einige der Transistoren (Tᵢ) ein zusätzliches Widerstandselement (R'ᵢ) zwischen dem Drain oder der Source des Transistors und einem der Anschlüsse des Satzes (Dᵢ) gekoppelt ist.

2. Optoelektronische Schaltung nach Anspruch 1, wobei N eine ganze Zahl in dem Bereich von 2 bis 200 ist, und wobei die Vielzahl von Sätzen (Dᵢ) der Lichtemittierenden Dioden N-1 Sätze aufweisen.

3. Optoelektronische Schaltung nach Anspruch 1 bis 2, wobei wenigstens einige der Widerstandselemente (Rᵢ) unterschiedliche Widerstandswerte besitzen.

4. Optoelektronische Schaltung nach einem der Ansprüche 1 oder 3, wobei jedes Widerstandselement wenigstens einen elektrischen Widerstand aufweist.

5. Optoelektronische Schaltung nach einem der Ansprüche 1 bis 4, die ferner eine Vollwellengleichrichterschaltung (12) aufweist, die geeignet ist, die Spannung (V_{ALIM}) zu liefern.

6. Optoelektronische Schaltung nach einem der Ansprüche 1 bis 5, die eine integrierte Schaltung (45; 90) aufweist, die Sätze (Dᵢ) Licht-emittierender Dioden, die Widerstandselemente (Rᵢ) und die Transistoren (Tᵢ) aufweist.

7. Optoelektronische Schaltung nach einem der Ansprüche 1 bis 6, wobei jede Licht-emittierende Diode eine Planardiode ist.

8. Optoelektronische Schaltung nach einem der Ansprüche 1 bis 6, die eine integrierte Schaltung mit einem Träger (50, 56₁, 56₂) aufweist, wobei die Sätze Licht-emittierender Dioden (Dᵢ) an dem Träger liegen, wobei jede Licht-emittierende Diode wenigstens ein leitungsförmiges, kegelförmiges oder kegelstumpfförmiges Halbleiterelement (60₁, 60₂) aufweist.

9. Optoelektronische Schaltung nach Anspruch 8, die ferner wenigstens eine Isolierschicht (58, 64) aufweist, die wenigstens teilweise den Träger (50, 56₁, 56₂) abdeckt, und für jeden Transistor (Tᵢ) ein Halbleiterteil (70) aufweist, das sich an der Isolierschicht erstreckt und die Source, den Drain des Transistors und den Kanal des Transistors bildet, wobei ein Isolierteil (72) den Halbleiterteil an der Seite gegenüber der Isolierschicht abdeckt und den Gateisolierer des Transistors bildet.

10. Optoelektronische Schaltung nach Anspruch 8, wobei der Träger (50, 56₁, 56₂) ein nicht-dotiertes oder dotiertes Halbleitersubstrat (50) eines ersten Leitfähigkeitstyps aufweist, wobei die optoelektronische Schaltung für jeden Transistor (Tᵢ) dotierte Halbleiterbereiche (94, 92, 54₁) eines zweiten Leitfähigkeitstyps aufweist, der stärker dotiert ist als das Substrat, die sich in das Substrat erstrecken und die Source, den Drain und den Kanal des Transistors bilden, und der Isolierteil (72) sich an dem Substrat erstreckt und den Gateisolierer des Transistors bildet.

## Claims

1. An optoelectronic circuit (30; 40) intended to receive a variable voltage (V_{ALIM}) containing an alternation of increase and decrease phases, the optoelectronic circuit comprising:
- an alternation of N resistive elements (Rᵢ) and of N sets (Dᵢ) of light-emitting diodes, the resistive elements (Rᵢ) being series-assembled with the sets (Dᵢ), each set (Dᵢ) comprising two terminals, each i^{th} resistive element (Rᵢ), for i in the range from 1 to N-1, being interposed between two successive sets (Dᵢ) ;
- a transistor (Tᵢ) for each set (Dᵢ) from among a plurality of said sets (Dᵢ), **characterized in that**
the transistor (Tᵢ) is a depletion metal-oxide gate field effect transistor having its drain and its source coupled to the terminals of said set and having its gate coupled to one of the terminals of the next set, and
**in that**
for at least some of the transistors (Tᵢ), an additional resistive element (R'ᵢ) is coupled between the drain or the source of the transistor and one of the terminals of said set (Dᵢ).

2. The optoelectronic circuit of claim 1, wherein N is an integer in the range from 2 to 200, and wherein the plurality of sets (Dᵢ) of light-emitting diodes comprises N-1 sets.

3. The optoelectronic circuit of claim 1 or 2, wherein at least some of the resistive elements (Rᵢ) have different resistance values.

4. The optoelectronic circuit of any of claims 1 to 3, where each resistive element comprises at least one electric resistor.

5. The optoelectronic circuit of any of claims 1 to 4, further comprising a fullwave rectifying circuit (12) capable of supplying said voltage (V_{ALIM}).

6. The optoelectronic circuit of any of claims 1 to 5, comprising an integrated circuit (45; 90) comprising the sets (Dᵢ) of light-emitting diodes, the resistive elements (Rᵢ), and the transistors (Tᵢ).

7. The optoelectronic circuit of any of claims 1 to 6, wherein each light-emitting diode is a planar diode.

8. The optoelectronic circuit of any of claims 1 to 6, comprising an integrated circuit comprising a support (50, 56₁, 56₂), the sets of light-emitting diodes (Dᵢ) resting on the support, each light-emitting diode comprising at least one wire-shaped, conical, or frustoconical semiconductor element (60₁, 60₂).

9. The optoelectronic circuit of claim 8, further comprising at least one insulating layer (58, 64) at least partially covering the support (50, 56₁, 56₂) and, for each transistor (Tᵢ), a semiconductor portion (70) extending on the insulating layer and forming the source, the drain of the transistor, and the channel of the transistor, an insulating portion (72) covering the semiconductor portion on the side opposite to the insulating layer and forming the gate insulator of the transistor.

10. The optoelectronic circuit of claim 8, wherein the support (50, 56₁, 56₂) comprises a non-doped or doped semiconductor substrate (50) of a first conductivity type, the optoelectronic circuit comprising, for each transistor (Tᵢ), doped semiconductor regions (94, 92, 54₁) of a second conductivity type, more heavily doped than the substrate, extending into the substrate and forming the source, the drain, and the channel of the transistor and an insulating portion (72) extending on the substrate and forming the gate insulator of the transistor.
